# EUROPEAN PATENT APPLICATION

(11) **EP 4 080 721 A1**
(43) Date of publication of application: **26.10.2022**
(21) Application number: 22163502.2
(22) Date of filing: 22.03.2022
(51) Int. Cl.: H02J 7/00, H02J 9/06, G01R 1/04, G01R 31/36, H01M 10/42, G01R 31/371, G01R 31/382

(54) **WIRELESS MONITORING AND MANAGEMENT OF UPS BATTERY MODULES AND OTHER ACCESSORIES**

(30) Priority: 23.04.2021 US 202117238269
(71) Applicant: Schneider Electric IT Corporation, Foxboro, MA 02035 (US)
(72) Inventor: PATEL, Kaushal J., Lowell, Massachusetts (MA), 01854 (US); BEG, Mirza Akmal, Pepperell, Massachusetts (MA), 01463 (US)
(74) Representative: Murgitroyd & Company

(57) **Abstract**

A battery monitoring device (200) including a housing (202) configured to be attached to a battery, at least one memory element (208) included in the housing, the at least one memory element being configured to store data corresponding to the battery, and a device controller(206) included in the housing, the device controller being coupled to the at least one memory element and configured to communicate over a first communication interface (204) with an external controller.

## Description

### BACKGROUND

### 1. Field of Invention

Embodiments of this disclosure relate generally to battery modules, and more particularly, to the wireless monitoring and management of battery modules.

### 2. Discussion of Related Art

An uninterruptible power supply (UPS) is used to provide backup power to an electrical device, or load, when the primary power source, or mains, fails. Typical loads include computer systems, but other loads, such as heating/cooling/ventilation systems, lighting systems, network switches and routers, and security data center management systems may also receive backup power between 1 and 20 kVA for several hours. In many cases, the backup power is provided by one or more batteries. Such batteries can have different maintenance and performance characteristics based on the manufacturer, life cycle, operating environment, capacity, etc.

### SUMMARY

At least one aspect of the present disclosure is directed to a battery monitoring device including a housing configured to be attached to a battery, at least one memory element included in the housing, the at least one memory element being configured to store data corresponding to the battery, and a device controller included in the housing, the device controller being coupled to the at least one memory element and configured to communicate over a first communication interface with an external controller.

In one embodiment, the first communication interface is a wireless communication interface. In some embodiments, the battery monitoring device is one of a plurality of battery monitoring devices attached to a plurality of batteries. In various embodiments, the battery is coupled to an Uninterruptible Power Supply (UPS) and the external controller is included in the UPS. In certain embodiments, a first portion of the at least one memory element includes first data corresponding to the battery and a second portion of the at least one memory element includes second data corresponding to at least one of performance of the battery and operation of the UPS.

In some embodiments, the device controller is configured to provide the first data to the external controller and receive the second data from the external controller and/or provide the second data to the external controller. In one embodiment, at least one of the first data and the second data provides an indication to replace the battery.

Another aspect of the present disclosure is directed to a battery monitoring system including a battery monitoring device including a housing configured to be attached to a battery, at least one memory element configured to store data corresponding to the battery, and a first controller coupled to the at least one memory element, the at least one memory element and the first controller being included in the housing, and a second controller configured to communicate over a first communication interface with the first controller of the battery monitoring device and communicate over a second communication interface with a server to provide information corresponding to the battery.

In one embodiment, the first communication interface is a wireless communication interface. In some embodiments, the second controller is configured to communicate over the second communication interface with a management application hosted on the server. In various embodiments, the second controller is included in an Uninterruptible Power Supply (UPS) coupled to the battery and the second controller is further configured to receive instructions for operating the UPS from the management application. In certain embodiments, the instructions for operating the UPS includes a notification to replace the battery.

In some embodiments, a first portion of the at least one memory element of the battery monitoring device includes first data corresponding to the battery and a second portion of the at least one memory element of the battery monitoring device includes second data corresponding to at least one of performance of the battery and operation of the UPS. In one embodiment, the instructions for operating the UPS provided by the management application are based on at least one of the first and second data. In certain embodiments, the first controller of the battery monitoring device is configured to provide the first data to the second controller and receive the second data from the second controller and/or provide the second data to the second controller. In various embodiments, the second controller is configured to provide at least one of the first data and the second data to the management application.

Another aspect of the present disclosure is directed to a non-transitory computer-readable medium storing thereon sequences of computer-executable instructions for controlling a battery monitoring device including a housing configured to be attached to a battery and at least one memory element configured to store data corresponding to the battery. The sequences of computer-executable instructions include instructions that instruct at least one processor to access first data corresponding to the battery stored in a first portion of the at least one memory element of the battery monitoring device, transmit the first data to an external controller included in an external system, receive second data corresponding to at least one of performance of the battery and operation of the external system, and store the second data in a second portion of the at least one memory element of the battery monitoring device.

In one embodiment, the external system is an Uninterruptible Power Supply (UPS) and the battery is coupled to the UPS. In some embodiments, transmitting the first data to the external controller includes transmitting the first data over a first communication interface and receiving the second data over the first communication interface. In various embodiments, the first communication interface is a wireless communication interface. In certain embodiments, the sequences of computer-executable instructions include instructions that instruct at least one processor to transmit at least one of the first data and the second data over a second communication interface to a management application.

In some embodiments, the sequences of computer-executable instructions include instructions that instruct at least one processor to operate the management application to provide operational instructions over the second communication interface based on at least one of the first and second data. In one embodiment, the operational instructions include a notification to replace the battery.

Another aspect of the present disclosure is directed to a battery monitoring device including a housing configured to be attached to a battery, at least one memory element included in the housing, the at least one memory element being configured to store data corresponding to the battery, and a device controller included in the housing, the device controller being coupled to the at least one memory element and configured to communicate over a first communication interface with an external controller.

In one embodiment, the first communication interface is a wireless communication interface. In some embodiments, the battery monitoring device is one of a plurality of battery monitoring devices attached to a plurality of batteries. In certain embodiments, the battery is coupled to an Uninterruptible Power Supply (UPS) and the external controller is included in the UPS. In various embodiments, a first portion of the at least one memory element includes first data corresponding to the battery.

In some embodiments, the housing of the battery monitoring device is configured to be attached to the battery during an assembly procedure that includes storing the first data in the first portion of the at least one memory element. In one embodiment, the device controller is configured to provide the first data to the external controller. In certain embodiments, a second portion of the at least one memory element includes second data corresponding to at least one of performance of the battery and operation of the UPS. In various embodiments, the device controller is configured to receive the second data from the external controller and/or provide the second data to the external controller.

In one embodiment, the external controller is configured to communicate over a second communication interface with a management application. In some embodiments, the external controller is configured to provide at least one of the first data and the second data to the management application. In various embodiments, the external controller is configured to receive instructions for operating the UPS from the management application based on at least one of the first and second data. In certain embodiments, the instructions include a notification to replace the battery.

Another aspect of the present disclosure is directed to a battery monitoring system including a battery monitoring device including a housing configured to be attached to a battery, at least one memory element configured to store data corresponding to the battery, and a first controller coupled to the at least one memory element, the at least one memory element and the first controller being included in the housing, and a second controller configured to communicate over a first communication interface with the first controller of the battery monitoring device and communicate over a second communication interface with a server to provide information corresponding to the battery.

In one embodiment, the first communication interface is a wireless communication interface. In some embodiments, the second controller is configured to communicate over the second communication interface with a management application hosted on the server. In various embodiments, the second controller is included in an Uninterruptible Power Supply (UPS) coupled to the battery and the second controller is further configured to receive instructions for operating the UPS from the management application. In certain embodiments, the instructions for operating the UPS includes a notification to replace the battery.

In some embodiments, a first portion of the at least one memory element of the battery monitoring device includes first data corresponding to the battery. In one embodiment, the first controller of the battery monitoring device is configured to provide the first data to the second controller. In various embodiments, a second portion of the at least one memory element of the battery monitoring device includes second data corresponding to at least one of performance of the battery and operation of the UPS. In certain embodiments, the instructions for operating the UPS provided by the management application are based on at least one of the first and second data.

In one embodiment, the first controller of the battery monitoring device is configured to receive the second data from the second controller and/or provide the second data to the second controller. In some embodiments, the second controller is configured to provide at least one of the first data and the second data to the management application.

Another aspect of the present disclosure is directed to a non-transitory computer-readable medium storing thereon sequences of computer-executable instructions for controlling a battery monitoring device including a housing configured to be attached to a battery and at least one memory element configured to store data corresponding to the battery. The sequences of computer-executable instructions include instructions that instruct at least one processor to access first data corresponding to the battery stored in a first portion of the at least one memory element of the battery monitoring device, transmit the first data to an external controller included in an external system, receive second data corresponding to at least one of performance of the battery and operation of the external system, and store the second data in a second portion of the at least one memory element of the battery monitoring device.

In one embodiment, the external system is an Uninterruptible Power Supply (UPS) and the battery is coupled to the UPS. In some embodiments, transmitting the first data to the external controller includes transmitting the first data over a first communication interface and receiving the second data over the first communication interface. In various embodiments, the first communication interface is a wireless communication interface. In certain embodiments, the external controller is configured to transmit at least one of the first data and the second data over a second communication interface to a management application.

In some embodiments, the external controller is configured to receive operational instructions over the second communication interface from the management application based on at least one of the first and second data. In one embodiment, the operational instructions include a notification to replace the battery.

Another aspect of the present disclosure is directed to a battery module including a battery and a battery monitoring device including at least one memory element configured to store data corresponding to the battery, and a device controller coupled to the at least one memory element and configured to communicate over a first communication interface with an external controller.

### BRIEF DESCRIPTION OF THE DRAWINGS

Various aspects of at least one embodiment are discussed below with reference to the accompanying figures, which are not intended to be drawn to scale. The figures are included to provide illustration and a further understanding of the various aspects and embodiments, and are incorporated in and constitute a part of this specification, but are not intended as a definition of the limits of the invention. In the figures, each identical or nearly identical component that is illustrated in various figures is represented by a like numeral. For purposes of clarity, not every component may be labeled in every figure. In the figures:
FIG. 1 is a functional block diagram of a UPS in accordance with aspects described herein;
FIG. 2 is a functional block diagram of a battery monitoring device in accordance with aspects described herein;
FIG. 3A is a functional block diagram of a power supply arrangement in accordance with aspects described herein;
FIG. 3B is a functional block diagram of a power supply arrangement in accordance with aspects described herein;
FIG. 4 is a functional block diagram of a battery monitoring system in accordance with aspects described herein;
FIG. 5 is a flow diagram of an operational sequence of a battery monitoring system in accordance with aspects described herein; and
FIG. 6 is a functional block diagram of a power supply arrangement in accordance with aspects described herein.

### DETAILED DESCRIPTION

Examples of the methods and systems discussed herein are not limited in application to the details of construction and the arrangement of components set forth in the following description or illustrated in the accompanying drawings. The methods and systems are capable of implementation in other embodiments and of being practiced or of being carried out in various ways. Examples of specific implementations are provided herein for illustrative purposes only and are not intended to be limiting. In particular, acts, components, elements and features discussed in connection with any one or more examples are not intended to be excluded from a similar role in any other examples.

Also, the phraseology and terminology used herein is for the purpose of description and should not be regarded as limiting. Any references to examples, embodiments, components, elements or acts of the systems and methods herein referred to in the singular may also embrace embodiments including a plurality, and any references in plural to any embodiment, component, element or act herein may also embrace embodiments including only a singularity. References in the singular or plural form are not intended to limit the presently disclosed systems or methods, their components, acts, or elements. The use herein of "including," "comprising," "having," "containing," "involving," and variations thereof is meant to encompass the items listed thereafter and equivalents thereof as well as additional items. References to "or" may be construed as inclusive so that any terms described using "or" may indicate any of a single, more than one, and all of the described terms. In addition, in the event of inconsistent usages of terms between this document and documents incorporated herein by reference, the term usage in the incorporated references is supplementary to that of this document; for irreconcilable inconsistencies, the term usage in this document controls.

As discussed above, power devices, such as uninterruptible power supplies (UPS), may be used to provide regulated, uninterrupted power to sensitive and/or critical loads. An online UPS rectifies input AC power provided by an electric utility using a Power Factor Correction converter circuit (PFC) to provide DC power to at least one DC bus. The rectified DC power on the DC bus(es) may be used to charge a battery while mains power is available. In the absence of mains power, the battery discharges and provides DC power to the DC bus(es). From the DC power on the DC bus(es), an inverter generates an AC output voltage that is provided to a load. Since power is provided to the DC bus(es) from either mains or the battery, the output power of the UPS is uninterrupted if the mains fails and the battery is sufficiently charged. Online UPS's may also operate in a bypass mode where unconditioned power with basic protection is provided directly from an AC power source to a load via a bypass line.

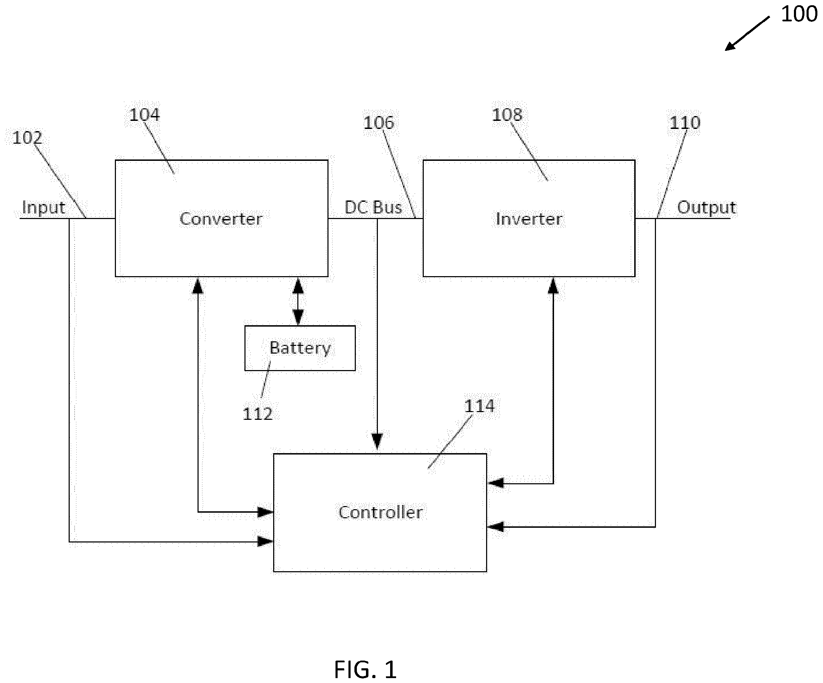

FIG. 1 is a block diagram of one embodiment of an online UPS 100 that can provide regulated power, derived from input AC power received at an input 102 and/or back-up DC power from a battery 112, to an output 110. In some examples, the battery 112 may be included in the UPS 100; however, in other examples, the battery 112 may be external to the UPS 100. The UPS 100 includes a converter 104, a DC bus 106, an inverter 108, and a controller 114 for controlling the converter 104 and the inverter 108. The DC bus 106 is coupled between the converter 104 and the inverter 108.

The input 102 is configured to receive input AC power having an input voltage level from an AC power source. The controller 114 monitors the input AC power received by the input 102 and is configured to operate the UPS 100 in different modes of operation based on the status of the input AC power received by the input 102. When AC power provided to the input 102 is acceptable (i.e., above an input power quality threshold), the controller 114 operates the UPS 100 in an online mode of operation.

In the online mode of operation, AC power from the input 102 is provided to the converter 104. The controller 114 operates the converter 104 to convert the AC power into DC power and provide the DC power to the DC bus 106. DC power from the DC bus 106 is provided to the inverter 108. In addition, DC power from the DC bus 106 may be provided to the battery 112 for charging, either directly from the converter 104 or via a separate DC/DC converter (e.g., a charger). The controller 114 operates the inverter 108 to convert the DC power from the DC bus into regulated AC power and provide the regulated AC power to a load coupled to the output 110.

When AC power provided to the input 102 is not acceptable (i.e., below an input power quality threshold), the controller 114 operates the UPS 100 in a backup mode of operation. In the backup mode of operation, DC power from the battery 112 is provided to the DC bus 106. The inverter 108 receives the DC power from the DC bus 106, and the controller 114 operates the inverter 108 to convert the DC power from the DC bus 106 into regulated AC power and provide the regulated AC power to the output 110.

In some examples, the battery 112 may have specific maintenance and/or performance characteristics based on the manufacturer, chemistry, life cycle, operating environment, capacity, etc. of the battery 112. In some cases, the battery 112 may be one of a plurality of different batteries having different maintenance and/or performance characteristics. In some Online UPS systems, the battery 112 may be unable to communicate with the UPS 100 and provide these characteristics to the UPS 100. As such, the UPS 100 may be configured to operate with generic battery operations (or algorithms) to support each of the different batteries. However, the use of such generic battery operations/algorithms can reduce the efficiency and/or performance of the UPS 100. In addition, due to the lack of communication between the battery 112 and the UPS 100, the UPS 100 may be unaware of impending reliability issues associated with the battery 112. For example, if the battery 112 is experiencing health issues, the UPS 100 may not be aware until performance is impacted, exposing the UPS 100 to potential reliability issues. Likewise, the UPS 100 may send a notification to the user/customer after observing reduced performance of the battery 112, leaving the UPS 100 exposed to potential reliability issues until the battery 112 is replaced.

In addition, the battery 112 may be interchanged or swapped between different UPSs. For example, the user/customer may upgrade or switch to a new UPS model/configuration and transfer the battery from the old UPS to the new UPS. Alternatively, the user/customer may swap batteries between two or more UPSs based on different operating conditions or other user preferences. As such, the UPSs may be generally unaware of the operational history, performance capabilities, and health of their batteries. In some examples, the UPS may utilize a battery management system to monitor the battery; however, data collected by the battery monitoring system remains local to the UPS (or the battery monitoring system) and does not travel with the battery once it is swapped or replaced.

Accordingly, improved systems and methods for battery monitoring are provided herein. In at least one embodiment, a battery monitoring device is attached to a battery and configured to provide and receive data corresponding to the battery. In some examples, the battery is coupled to a UPS and the battery monitoring device is configured to communicate with the UPS to provide and receive data corresponding to the battery. In certain examples, the UPS is configured to communicate with a management application to provide data corresponding to the battery and to receive operational instructions based on the data corresponding to the battery.

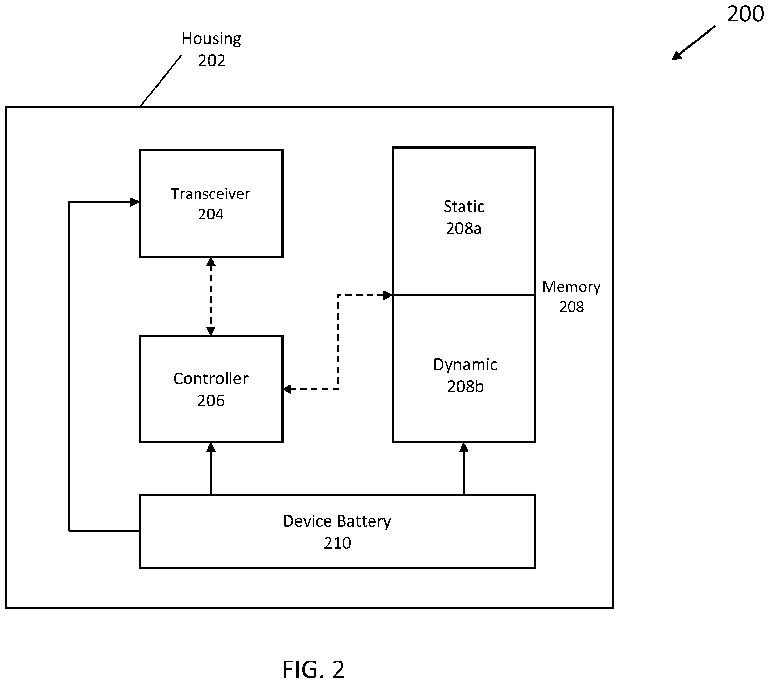

FIG. 2 is a block diagram of a battery monitoring device 200 in accordance with aspects described herein. As shown, the battery monitoring device 200 includes a housing 202, a transceiver 204, a controller 206, a memory device 208, and a device battery 210. In one example, the controller 206 is configured to communicate with both the transceiver 204 and the memory device 208. In some examples, the device battery 210 is configured to power the transceiver 204, the controller 206, and the memory device 208. In certain examples, the device battery 210 may be rechargeable; however, in other examples, the device battery 210 may be a single use battery having an extended battery life (e.g., 15 years).

In one example, the housing 202 is configured to house the transceiver 204, the controller 206, the memory device 208, and the device battery 210. In some examples, the housing 202 is an enclosure; however, in other examples, the housing 202 may be a platform, surface, substrate, or circuit board to which the components of the battery monitoring device 200 are attached, coupled, fixed, and/or bounded to. In certain examples, the housing 202 is configured to be attached to the enclosure of a battery (e.g., the battery 112) or battery module. The housing 202 may be attached to the battery enclosure externally or internally.

In one example, the transceiver 204 is configured to communicate over a wireless communication interface. For example, the transceiver 204 may communicate over a wireless personal area network, such as Bluetooth (e.g., BLE), WiFi, ZigBee, etc. In some examples, the transceiver 204 is configured to communicate over a wireless communication interface to send and receive information or data.

In various examples, the controller 206 may include one or more processors or microcontrollers. The controller 206 may include specially programmed, special-purpose hardware, for example, an application-specific integrated circuit (ASIC), or more generally designed hardware, such as a field programmable gate array (FPGA) or a processor. In some examples, the controller 206 may be one or more controllers including one or more components such as one or more processors.

In one example, the memory device 208 may be one or more memory devices, such as a disk drive, memory, flash memory, embedded or on-chip memory, or other device for storing data. As shown, the memory device 208 may include a static portion 208a and a dynamic portion 208b. In some examples, the static portion 208a is configured to store static data corresponding to the battery. The static data may include, for example, the battery vendor, the battery serial number, the battery chemistry, the manufacture date of the battery, and various performance parameters or specifications of the battery. In certain examples, the static portion 208a of the memory device 208 may be read-only memory. Likewise, the dynamic portion 208b is configured to store dynamic data corresponding to the battery. The dynamic data may include, for example, the in-service date(s) of the battery, the number of battery cycles, the health of the battery, the depth of discharge of the battery, the average load on the battery, the average temperature of the battery or the operational environment, and the humidity of the operational environment. In certain examples, the dynamic portion 208b of the memory device 208 may be configured as read-write memory.

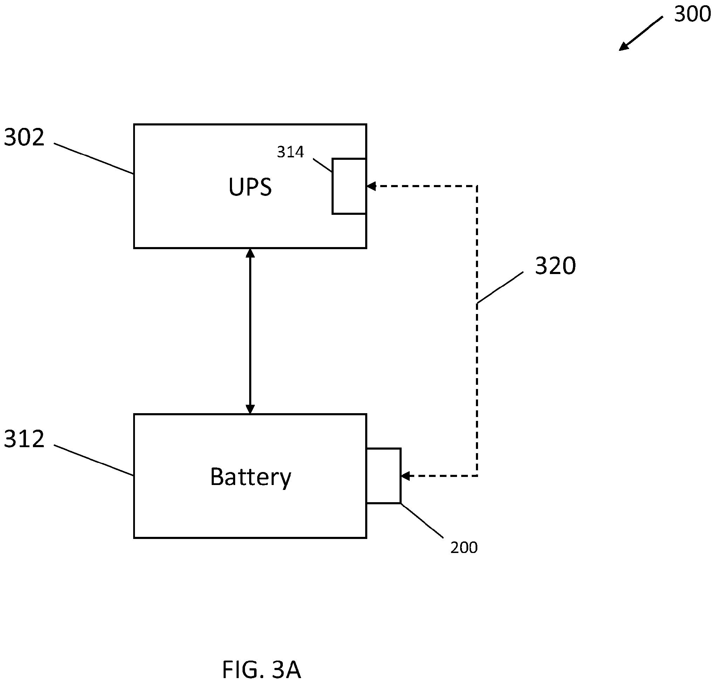

FIG. 3A is a block diagram of a power supply arrangement 300 including the battery monitoring device 200 in accordance with aspects described herein. In one example, the power supply system 300 includes a UPS 302 coupled to a battery 312. In some examples, the UPS 302 corresponds to the UPS 100 and the battery 312 corresponds to the battery 112 of FIG. 1; however, in other examples, the UPS 302 may correspond to a different type of UPS (e.g., an offline UPS). As shown, the battery monitoring device 200 is attached to the outside of the housing or enclosure of the battery 312.

In one example, the UPS 302 includes a controller 314 (e.g., the controller 114) and the battery monitoring device 200 is configured to communicate with the controller 314 via a wireless communication interface 320 (e.g., Bluetooth, ZigBee, WiFi, etc.). In some examples, the controller 314 includes a transceiver; e.g., similar to the transceiver 204 of the battery monitoring device 200. The battery monitoring device 200 can provide data corresponding to the battery 312 to the controller 314. The battery monitoring device 200 may provide (i.e., transmit) the static data and/or the dynamic data stored in the memory device 208 to the controller 314. The controller 314 can receive the data from the battery monitoring device 200 and adjust one or more operational parameters of the UPS 302 (e.g., charging profile, converter duty cycle(s), backup support time, etc.) based on the received data. In some examples, the controller 314 is configured to adjust the one or more operational parameters to improve the performance of the UPS 302 while extending the life of the battery 312. Likewise, the controller 314 may provide (i.e., transmit) data corresponding to the operation of the UPS 302 and/or usage of the battery 312 to the battery monitoring device 200. The battery monitoring device 200 can receive the data from the controller 314 and store the data in the memory device 208. In some examples, the battery monitoring device 200 may store the data by updating existing data entries and/or by adding new data entries within the dynamic portion 208a of the memory device 208.

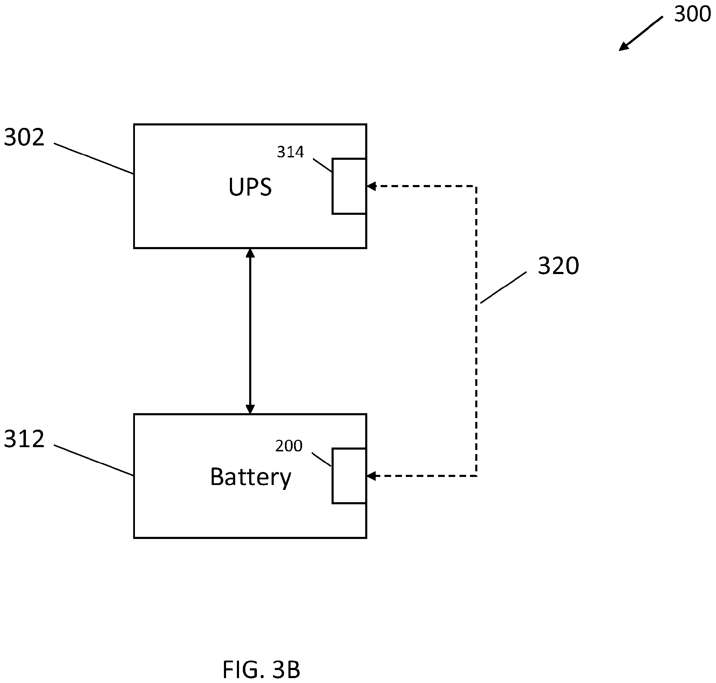

While the battery monitoring device 200 is described above as being attached to the outside of the housing/enclosure of the battery 312, in other examples, the battery monitoring device 200 can be integrated with the battery 312 in a different manner. For example, as shown in FIG. 3B, the battery monitoring device 200 can be included within the housing/enclosure of the battery 312. For example, the battery monitoring device 200 may be attached to the inside of the housing or enclosure of the battery 312. In some examples, the battery monitoring device 200 is installed within the housing or enclosure of the battery 312 during manufacturing or assembly of the battery 312; however, in other examples, the battery monitoring device 200 can be installed at a different time (e.g., before delivering the battery 312 with the UPS 302 to the user/customer).

Being that the battery monitoring device 200 is attached to the housing/enclosure the battery 312 (or included within), if the battery 312 is removed from the power supply arrangement 300 and integrated into a new power supply arrangement, the battery monitoring device 200 and the data stored in the memory device 208 can be transferred over to the new power supply arrangement. For example, if the battery 312 is decoupled from the UPS 302 and coupled to a new UPS, the battery monitoring device 200 may provide data from the memory device 208 to the new UPS, including data corresponding to the operational history and health of the battery 312. As such, the new UPS may adjust one or more operational parameters to provide desired performance based on the current state or health of the battery 312 and/or the operational history of the battery 312.

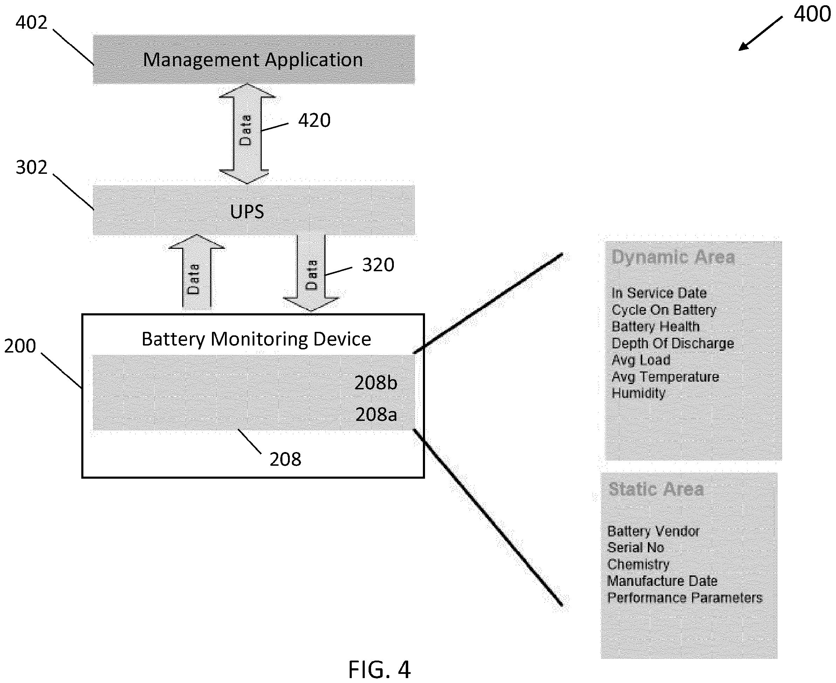

FIG. 4 is a block diagram of a battery monitoring system 400 in accordance with aspects described herein. In one example, the battery monitoring system 400 includes the battery monitoring device 200, the UPS 302, and a management application 402. While not shown, the battery monitoring device 200 is configured to be attached to the battery 312 that is coupled to the UPS 302.

As described above, the battery monitoring device 200 is configured to communicate with the UPS 302 via the wireless communication interface 320 using the transceiver 204 of FIG. 2. In one example, the wireless communication interface 320 is a wireless personal area network, such as Bluetooth (e.g., BLE), WiFi, ZigBee, etc. In some examples, the battery monitoring device 200 can provide data corresponding to the battery to the UPS 302. For example, the battery monitoring device 200 may provide (i.e., transmit) the static data stored in the static portion 208a of the memory device 208 and/or the dynamic data stored in the dynamic portion 208b of the memory device 208 to the UPS 302. The UPS 302 can receive the data from the battery monitoring device 200 and adjust one or more operational parameters of the UPS 302 based on the received data. Likewise, the UPS 302 may provide (i.e., transmit) data corresponding to the operation of the UPS 302 and/or usage of the battery 312 to the battery monitoring device 200. The battery monitoring device 200 can receive the data from the UPS 302 and store the data in the dynamic portion 208b or the memory device 208.

In some examples, the management application 402 corresponds to one or more applications hosted on one or more servers. In certain examples, the servers may be physically located in the same location as the UPS 302 and the battery monitoring device 200; however, in other examples, the server(s) can be at different locations.

As shown, the UPS 302 (with the controller 314) is configured to communicate with the management application 402 via a communication interface 420. In some examples, the communication interface 420 is a wireless communication interface, such as Bluetooth (e.g., BLE), WiFi, ZigBee, etc. However, in other examples, the communication interface 420 may be a wired communication interface, such as a wired network connection (e.g., Ethernet) or a wired communication protocol (e.g., SPI, USB, etc.). In one example, the UPS 302 can provide data corresponding to the battery 312 and/or operation of the UPS 302 to the management application 402. For example, the UPS 302 may provide (i.e., transmit) data corresponding to the static data and/or the dynamic data stored on the battery monitoring device 200 to the management application 402. Likewise, the management application 402 may provide operational instructions or settings to the UPS 302. In some examples, the operational instructions or settings are provided by the management application 402 in response to the data provided by the UPS 302 to the management application 402. In other examples, the operational instructions or settings can be provided to the UPS 302 based on a user/customer command or action.

In one example, the management application 402 can be tailored for different uses depending on a specific application or user/customer. For example, for users/customers having many deployed UPS systems, the management application 402 may provide a user interface for the customer to monitor, maintain, and control a fleet of UPS systems. Likewise, the management application 402 may provide access to the fleet of UPS systems for a third-party or independent management company. In addition, the management application 402 may provide a user interface for monitoring, maintaining, and controlling a single UPS or a small group of UPS systems.

In some examples, the management application 402 is configured to provide a variety of monitoring and management functions. For example, the management application 402 may be configured to calculate the state of health (SOH) of the battery 312 based on the data provided from the UPS 302 and/or the battery monitoring device 200. In some examples, the management application 402 can provide the calculated SOH to the UPS 302 and the UPS 302 may adjust one or more operational settings accordingly. In one example, the management application 402 can provide a notification to replace the battery 312 in response to the SOH falling below a threshold (e.g., 60% of normal health). In some examples, the management application 402 is configured to calculate the SOH of the battery 312 periodically and the users/customers can observe the calculated SOHs over time via the management application 402. The management application 402 may provide an alert to order a replacement battery. In some examples, the management application 402 may automatically order a replacement battery once the alert is triggered. In addition, the UPS 302 may provide the calculated SOHs to the battery monitoring device 200 and the battery monitoring device 200 may store the calculated SOH in the memory device 208 (e.g., the dynamic portion 208b). In the event the battery 312 is moved to a different UPS, the new UPS will have access to the previously calculated SOHs of the battery 312.

In some examples, in response to determining that the battery 312 should be replaced or may need replacement soon, the management application 402 can instruct the UPS 302 to perform one or more diagnostic tests on the battery 312. The UPS 302 may receive instructions for specific diagnostic tests from the management application 402 corresponding to specific types of batteries and/or battery failures. In one example, the results of the diagnostic tests may be stored in the memory device 208 (e.g., the dynamic portion 208b) of the battery monitoring device 200 and/or in a database managed by the management application 402. In some examples, codes corresponding to the diagnostic tests performed or the results of the diagnostic tests can be stored in the battery monitoring device 200. Such information may be used to repair the battery 312, perform failure analysis investigations, and to track failures based on battery types, locations, usage patterns, etc. In certain examples, the results of the diagnostic testing and/or the data stored in the memory device 208 of the battery monitoring device 200 can be used to determine if a warranty of the battery 312 or the UPS 302 has been voided by the user/customer.

In some examples, the management application 402 is configured to verify the serial number of the battery 312. For example, when the battery 312 is coupled to the UPS 302, the UPS 302 may provide the serial number of the battery 312 to the management application 402. The management application 402 may verify that the serial number of the battery 312 is registered in a user/customer database. If the battery 312 is a new battery, the management application may register the battery 312 in the user/customer database such that the battery 312 can be recognized and tracked over its service life. In some examples, by registering the serial number of the battery 312, the UPS 302 and the battery 312 can easily be identified if the battery 312 is included in a bad or recalled lot of batteries. For example, if a manufacturing defect is discovered by the vendor or user/customer, the effected batteries can be traced by serial number to identify the effected UPS systems. In addition, the management application 402 may utilize the serial number of the battery 312 to verify compatibility with the UPS 302. For example, the management application 402 may identify that that battery 312 is incompatible for use with the UPS 312 or other batteries coupled to the UPS 302 based on one or more parameters of the battery 312 (e.g., vendor, chemistry, etc.). If an incompatibility is detected, the management application 402 may warn or alert the user/customer before the battery 312 is deployed or operated with the UPS 302.

In one example, the management application 402 is configured to monitor and analyze the performance of the UPS 302 based on the location of the UPS 302. For example, the management application 402 may monitor and compare the performance of the UPS 302 relative to other UPS systems located in the same region (e.g., the Northeast). In some examples, based on climate characteristics and operating environment conditions, it may be expected that all UPS systems located in the same region will perform similarly. As such, any deviations in the performance of the UPS 302 relative to the regional group of UPS systems may indicate failure or an issue within the operating environment (e.g., an air flow instruction causing the battery 312 to overheat). In other examples, the management application 402 can monitor and analyze different groups of UPS systems. For example, the management application 402 may monitor and compare groups of UPS systems located at the same user/customer site (e.g., a retail store). In addition, the management application 402 may utilize the location of the UPS 302 to source a replacement battery when the battery 312 fails or needs replacement. In some examples, the management application 402 can locate a replacement battery (new or used) near the UPS 302 to minimize potential downtime of the UPS 302. In certain examples, the management application 402 can be configured to identify and locate a UPS system powering lower-priority equipment and can recommend a battery swap between the UPS 302 and the lower-priority UPS in the event of an unexpected failure of the battery 312.

In some examples, the management application 402 is configured to monitor and analyze the performance of UPS groups to compare the performance of batteries provided by different vendors. For example, the analysis provided by the management application 402 may be used to assess the performance of batteries in different regions/environments and determine future supply orders from different battery vendors and suppliers.

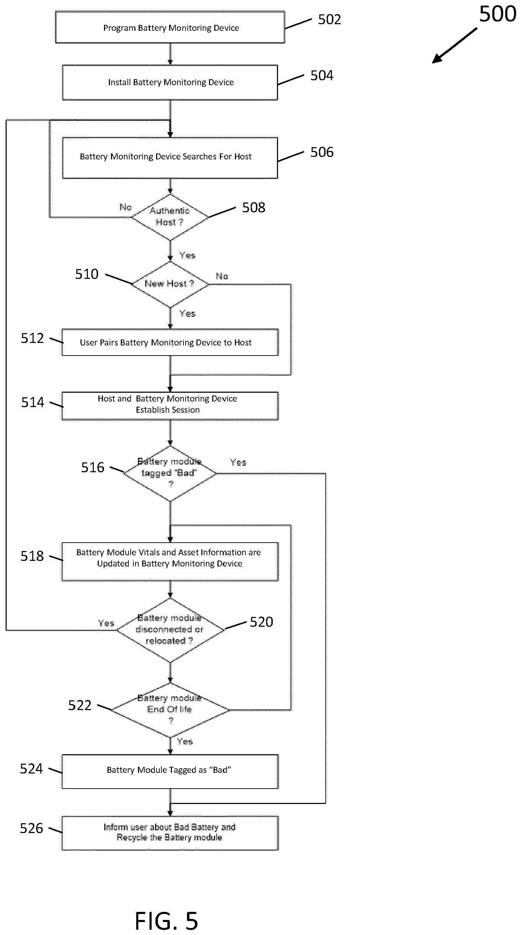

FIG. 5 is a flow chart representing an operational sequence 500 of the battery monitoring system 400. In one example, the steps included in the operational sequence 500 correspond to actions carried out by the battery monitoring device 200, the UPS 302, the management application 402, and the user/customer.

At block 502, the battery monitoring device 200 is pre-programmed with parameters corresponding to the battery 312. In one example, the pre-programming of the battery monitoring device 200 includes loading static data into the static portion 208a of the memory device 208. At block 504, the battery monitoring device 200 is installed with the battery 312. As described above, the battery monitoring device 200 is configured to be attached to or within the enclosure/housing of the battery 312. In some examples, once installed, the battery monitoring device 200 is configured to start operating automatically.

At block 506, the battery monitoring device 200 begins operating by searching or listening for a host device. For example, the battery monitoring device 200 (or the transceiver 204) may enter a pairing mode to receive or request a connection with a host. At block 508, once a host has been detected, the battery monitoring device 200 is configured to verify that the host is authentic. In one example, battery monitoring device 200 is configured to verify the host is authentic if the host corresponds to a UPS. If the host is not verified as authentic (e.g., not a UPS, not a UPS owned by the user, etc.), the battery monitoring device 200 continues to search for an authentic host (i.e., returns to block 506).

At block 510, once the host has been verified as authentic (i.e., is a UPS), the battery monitoring device 200 checks if the host is a new (or undesignated) host. In one example, the battery monitoring device 200 may reference the pre-programmed parameters to determine whether the host is a new (or undesignated) host. At block 512, if the host is new, the user/customer may assist in manually pairing the battery monitoring device 200 to the host (block 512). In some examples, when pairing the battery monitoring device 200, the user/customer can provide location information (e.g., zip code, city, etc.). The location information can be used to track/locate the battery for sourcing replacement batteries or parts. In addition, the location information may be used by battery vendors/providers for supply chain and marketing purposes.

At block 514, after being paired with the host, the battery monitoring device 200 is configured to establish a new session with the host (i.e., the UPS 302). Once the session has been established, the UPS 302 may begin providing performance data to the battery monitoring device 200 for storage in the dynamic portion 208b of the memory device 208. Likewise, the battery monitoring device 200 may begin providing data (static or dynamic) to the UPS 302 for performance adjustments and/or for transfer to the management application 402.

At block 516, at least one of the battery monitoring device 200, the UPS 302, and the management application 402 is configured to check the state of the battery 312. If the battery 312 is tagged as "bad", the management application 402 is configured to inform or alert the user/customer that the battery 312 needs replacement (block 526). Otherwise, at block 518, the latest vitals and asset information corresponding to the battery 312 (i.e., dynamic data) are stored in the memory device 208 of the battery monitoring device 200.

At block 520, the battery monitoring device 200 is configured to verify that the connection to the host (i.e., the UPS 302) is active. If the connection is not active, indicating that the battery monitoring device 200 has been disconnected or the battery 312 has been relocated, the battery monitoring device 200 is configured to return to block 506 to search for a new host. Otherwise, at block 522, the battery monitoring device 200 is configured to check the current state of the battery 312. As described above, the management application 402 is configured to periodically calculate the state of health (SOH) of the battery 312 based on the data provided from the UPS 302 and/or the battery monitoring device 200. In some examples, the management application 402 is configured to periodically provide the calculated SOH to the UPS 302 for storage in the memory device 208 of the battery monitoring device 200. If the latest SOH indicates that the battery 312 is in good or acceptable condition, the battery monitoring device 200 returns to block 518 to receive the latest vitals and asset information corresponding to the battery 312 from the UPS 302 and/or the management application 402.

Alternatively, at block 524, if the latest SOH indicates that the battery 312 is nearing the end of service life, at least one of the battery monitoring device 200, the UPS 302, and the management application 402 is configured to tag the battery 312 as "bad." The battery 312 may be tagged as "bad' in the memory device 208 of the battery monitoring device 208 and/or in a database managed by the management application 402. At block 526, the management application 402 is configured to inform or alert the user/customer that the battery 312 needs replacement (block 526).

While the management application 402 is described above with respect to the battery monitoring system 400, it should be appreciated that the management application 402 is configured to monitor and manage a plurality of UPS systems (and batteries) simultaneously. Being that the management application 402 can be a cloud-based application, there may be no functional limit to the number of UPS systems (and battery monitoring devices) that the management application 402 can be scaled to support. Likewise, while the battery monitoring device 200 is described above as being attached to the housing/enclosure of the battery 312, it should be appreciated that the battery 312 may include a plurality of cells or modules and the battery monitoring device 200 may be configured as a group of devices attached to the individual cells or modules of the battery.

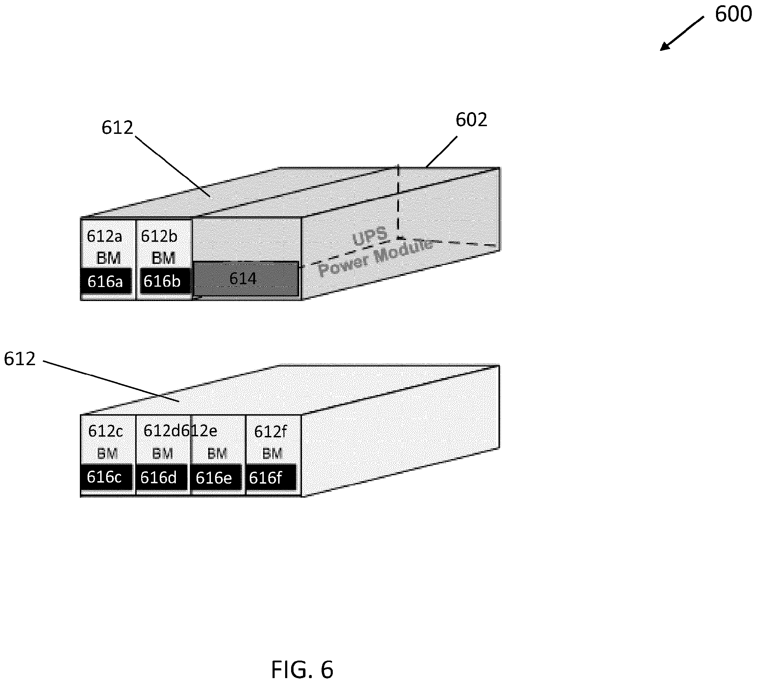

For example, FIG. 6 is a block diagram of a power supply arrangement 600 in accordance with aspects described herein. In one example, the power supply arrangement 600 includes a UPS 602, a battery 612, and a plurality of battery monitoring devices 616a-616f. As shown, the battery 612 includes a plurality of battery modules 612a-612f configured to be coupled to the UPS 602 (e.g., via a power module of the UPS) and the plurality of battery monitoring devices 616a-616f are configured to be attached to the enclosures/housings of each battery module 612a-612f.

In one example, each of the battery monitoring devices 616a-616f corresponds to the battery monitoring device 200 of FIG. 2. In some examples, each of the battery monitoring devices 616a-616f is configured to store data (e.g., static and dynamic) associated with the individual battery modules 612a-612f. In certain examples, each of the battery monitoring devices 616a-616f can communicate with a controller 614 of the UPS 602 over a wireless communication interface (e.g., Bluetooth, WiFi, ZigBee, etc.). In other examples, one of the battery monitoring devices 616a-616f can be designated as a master device configured to communicate with the controller 614 of the UPS 602 and the remaining devices can be designated as slave or control devices configured to communicate with the master device. For example, the battery monitoring device 616a may be configured to communicate with the UPS 602 and the battery monitoring devices 616b-616f may be configured to communicate with the UPS 602 via the battery monitoring device 616a.

As described above, the controller 614 of the UPS 602 can communicate with a management application (e.g., the management application 402) via a wireless or wired communication interface. In one example, the controller 614 is configured to provide data corresponding to the plurality of battery modules 612a-612f and/or operation of the UPS 602 to the management application. For example, the controller 614 may provide (i.e., transmit) data corresponding to the static data and/or the dynamic data stored by the plurality of battery monitoring devices 616a-616f to the management application. Likewise, the management application may provide operational instructions and/or settings to the controller 614. In some examples, the operational instructions or settings are provided by the management application in response to the data provided by the controller 614 to the management application. In other examples, the operational instructions or settings can be provided to the controller 614 based on a user/customer command or action. In certain examples, the operational instructions provided by the management application may include a notification or alert to replace one or more of the battery modules 612a-612f.

As described above, improved systems and methods for battery monitoring are provided herein. In at least one embodiment, the battery monitoring device is attached to a battery and configured to provide and receive data corresponding to the battery. In some examples, the battery is coupled to a UPS and the battery monitoring device is configured to communicate with the UPS to provide and receive data corresponding to the battery. In certain examples, the UPS is configured to communicate with a management application to provide data corresponding to the battery and to receive operational instructions based on the data corresponding to the battery. As such, the data provided between the battery monitoring device, the UPS, and the management application can be used to improve the performance of the UPS and extend the life of the battery. In addition, the operational history, performance capabilities, and health of the battery can be traced over the service life of the battery, including periods of use between different UPS systems.

Having thus described several aspects of at least one embodiment of this invention, it is to be appreciated various alterations, modifications, and improvements will readily occur to those skilled in the art. Such alterations, modifications, and improvements are intended to be part of this disclosure and are intended to be within the scope of this invention.
Accordingly, the foregoing description and drawings are by way of example only.

## Claims

1. A battery monitoring system comprising:
a battery monitoring device including a housing configured to be attached to a battery, at least one memory element configured to store data corresponding to the battery, and a first controller coupled to the at least one memory element, the at least one memory element and the first controller being included in the housing; and
a second controller configured to communicate over a first communication interface with the first controller of the battery monitoring device and communicate over a second communication interface with a server to provide information corresponding to the battery.

2. The battery monitoring system of claim 1, wherein the first communication interface is a wireless communication interface.

3. The battery monitoring system of claim 1, wherein the second controller is configured to communicate over the second communication interface with a management application hosted on the server.

4. The battery monitoring system of claim 3, wherein the second controller is included in an Uninterruptible Power Supply (UPS) coupled to the battery and the second controller is further configured to receive instructions for operating the UPS from the management application.

5. The battery monitoring system of claim 4, wherein the instructions for operating the UPS includes a notification to replace the battery.

6. The battery monitoring system of claim 4, wherein a first portion of the at least one memory element of the battery monitoring device includes first data corresponding to the battery and a second portion of the at least one memory element of the battery monitoring device includes second data corresponding to at least one of performance of the battery and operation of the UPS.

7. The battery monitoring system of claim 6, wherein the instructions for operating the UPS provided by the management application are based on at least one of the first and second data.

8. The battery monitoring system of claim 6, wherein the first controller of the battery monitoring device is configured to:
provide the first data to the second controller; and
receive the second data from the second controller and/or provide the second data to the second controller.

9. The battery monitoring system of claim 8, wherein the second controller is configured to provide at least one of the first data and the second data to the management application.

10. A non-transitory computer-readable medium storing thereon sequences of computer-executable instructions for controlling a battery monitoring device including a housing configured to be attached to a battery and at least one memory element configured to store data corresponding to the battery, the sequences of computer-executable instructions including instructions that instruct at least one processor to:
access first data corresponding to the battery stored in a first portion of the at least one memory element of the battery monitoring device;
transmit the first data to an external controller included in an external system;
receive second data corresponding to at least one of performance of the battery and operation of the external system; and
store the second data in a second portion of the at least one memory element of the battery monitoring device.

11. The non-transitory computer-readable medium of claim 10, wherein transmitting the first data to the external controller includes transmitting the first data over a first communication interface and receiving the second data over the first communication interface.

12. The non-transitory computer-readable medium of claim 11, wherein the first communication interface is a wireless communication interface.

13. The non-transitory computer-readable medium of claim 10, wherein the sequences of computer-executable instructions include instructions that instruct at least one processor to:
transmit at least one of the first data and the second data over a second communication interface to a management application.

14. The non-transitory computer-readable medium of claim 13, wherein the sequences of computer-executable instructions include instructions that instruct at least one processor to:
operate the management application to provide operational instructions over the second communication interface based on at least one of the first and second data.

15. The non-transitory computer-readable medium of claim 14, wherein the operational instructions include a notification to replace the battery.
